# EUROPEAN PATENT SPECIFICATION

(11) **EP 1 691 407 B1**
(45) Date of publication and mention of the grant of the patent: **22.07.2009**
(21) Application number: 05005474.1
(22) Date of filing: 14.03.2005
(51) Int. Cl.: H01L 21/765, H01L 21/329, H01L 27/08, H01L 29/06, H01L 29/872

(54) **Integrated circuit having a Schottky diode with a self-aligned floating guard ring and method for fabricating such a diode**
Integrierter Schaltkreis mit einer Schottky-Diode mit selbst-justiertem Schwebe-Schutzring und zugehöriges Herstellungsverfahren
Circuit intégré avec une diode Schottky à anneau de garde flottante auto-aligné et son procédé de fabrication

(30) Priority: 11.02.2005 EP 05002931
(43) Date of publication of application: 16.08.2006
(73) Proprietor: EM Microelectronic-Marin SA, 2074 Marin (CH)
(72) Inventor: Pardoen, Matthijs, 2525 Le Landeron (CH)
(74) Representative: Ravenel, Thierry Gérard Louis

(56) References cited:
- US-B1- 6 399 413
- US-B1- 6 525 389
- US-B1- 6 597 050
- US-B1- 6 683 362
- US-B1- 6 825 073
- PATENT ABSTRACTS OF JAPAN vol. 018, no. 171 (E-1529), 23 March 1994 (1994-03-23) -& JP 05 343660 A (MITSUBISHI ELECTRIC CORP), 24 December 1993 (1993-12-24)

## Description

### BACKGROUND OF THE INVENTION

The present invention relates generally to integrated circuits comprising diodes and in particular to an integrated circuit comprising at least one silicide-based Schottky diode with a guard ring. The present invention relates also to a very high frequency (UHF) passive transponder implementing such an integrated circuit and to a method for fabricating the Schottky diode.

A passive UHF radio-frequency identification (RFID) uses rectified energy of a radio wave to power-up a logic circuitry. A UHF transponder for implementing it includes an antenna and a monolithic integrated circuit which has on-chip Schottky diodes for direct current (DC) power-supply generation, since it is commonly admitted that the most efficient way to convert the incoming radio-frequency energy from the antenna is to use Schottky rectifiers.

Such an UHF transponder is disclosed in the article "Fully Integrated Passive UHF RFID transponder IC with 16.7-µW minimum RF input power" IEEE Journal of Solid-State Circuits, vol. 38, No 10, October 2003.

For improved reading distance, a small input capacitance is needed. Moreover, the rectifier structures implemented with Schottky diodes have reduced effectiveness when adding parallel capacitance; which corresponds to reducing the transit frequency of the Schottky device.

This reduced effectiveness expresses itself by having a lower rectified output DC voltage level for a given input alternative current (AC) radio-frequency signal level.

A silicide-based Schottky diode with a guard ring is disclosed in document US-B-6,597,050. The Schottky diode comprises a silicon substrate in which is formed an implant guard ring between an active Schottky area and a cathode contact area. A silicide layer forms the active Schottky area and covers the guard ring. The guard ring is used to reduce sharp edge effects. The use of this "implant" guard ring increases capacitance, hence decreases the transit frequency, which ultimately reduces the transponder's reading distance as less useful voltage is extracted from the electromagnetic field.

In document US-6,399,413 is disclosed a Schottky diode with a MOS-gate disposed between above-mentionned Schottky diode area and implant guard ring. The use of the gate improves the guard ring insulation without avoiding the rise of capacitance.

In the article "A Schottky-Barrier Diode with Self-Aligned Floating Guard Ring", by C. T. Chuang et al. (IEEE Transactions on electron devices, vol. ED-31. No 10, October 1984), it has been described a Schottky diode with a floating guard-ring in which the advantage of the guard ring is maintained while the depletion capacitance and charge storage are eliminated. However, the insulation method which is disclosed in this document is based on structures available only in an advanced bipolar technology and not applicable to CMOS technology.

In view of the foregoing, the invention is aimed to address the problems noted above and to provide an integrated circuit which still achieves a reduction of the sharp edge effects while not increasing capacitance.

### SUMMARY OF THE INVENTION

According to the present invention there is provided an integrated circuit having at least one on-chip silicide-based CMOS Schottky diode as recited in claim 1.

There is also provided a very high frequency passive transponder as recited in claim 7 and a method for fabricating the silicide-based Schottky diode as recited in claim 8.

This way, sharp electrode edge effects are avoided reducing leakage current while at the same time not adding capacitance to the Schottky diode device.

An advantage of the invention is that no technology changes or extra masks need to be added to implement the fabrication of the Schottky diode.

The integrated circuit according to the invention is particularly convenient for use as UHF transponder integrated circuit since reading distance is improved with lower transponder integrated circuit input capacitance and high frequency effective Schottky diode rectifier structures used for power-supply generation.

### BRIEF DESCRIPTION OF THE DRAWINGS

The preferred embodiment of this invention will be described in detail, with reference to the following figures. wherein like designations denote like elements, and wherein:
Fig 1 shows schematically a cross section of an integrated circuit comprising a silicide-based CMOS Schottky diode in accordance with a preferred embodiment of the present invention;
Fig. 2 shows schematically a first step of a method for fabricating the Schottky diode in accordance with the present invention;
Fig. 3 shows schematically a second step of the method comprising an implantation step;
Fig. 4 shows schematically a third step of the method comprising the deposition of a metal layer;
Fig. 5 shows schematically a fourth step of the method comprising a silicidation step.

### DETAILED DESCRIPTION

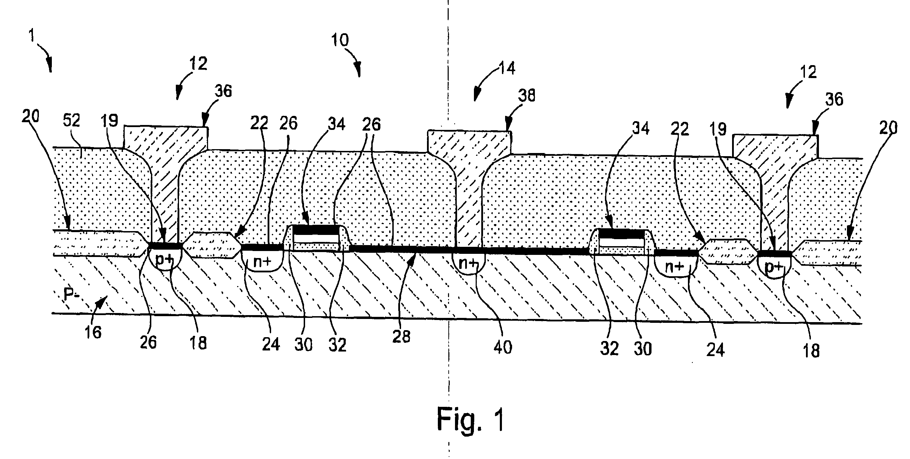

Referring to figure 1, an integrated circuit 1 having a silicide-based CMOS Schottky diode 10 in accordance with a preferred embodiment of the present invention is shown. Schottky diode 10 includes a cathode area 12 and an anode area 14. Schottky diode 10 is formed of a P- doped silicon substrate 16. In the present embodiment, the cathode contact area 19 is formed as a ring. Within P- substrate 16, in the cathode area 12, is a P+ doped silicon ring portion 18 which rises through P-substrate 16 to form a cathode contact area 19. Silicon oxide portions 20, 22 define the area around cathode contact area 19 and around anode area 14.

An implant guard ring 24 is formed by an area of a N+ doped silicon which surrounds the anode area 14.

A silicide layer 26 covers the substrate 16 in the cathode area 12, in the anode area 14, and in the area of the guard ring 24. The silicide layer 26 in the anode area 14 forms the active Schottky area 28.

In accordance with the present invention, the guard ring 24 is separated from the active Schottky area 28 by a MOS-gate ring 34. The sidewall oxide 30, 32 of the MOS-gate ring 34 provide two insulation rings 30, 32 between the guard ring 24 and the active Schottky area 28. Hence, a first insulation ring 30 is provided between the guard ring 24 and the MOS-gate ring 34 and a second insulation ring 32 is provided between the MOS-gate ring 34 and the active Schottky area 28.

One could note that the guard ring 24 is floating since it is insulated from the cathode contact area 19 by an oxide portion 22 and from the active Schottky area 28 by the internal 32 and external 30 sidewall oxide provided by the MOS-gate ring 34.

A metal substrate contact ring 36 is provided in the cathode area 12 and a metal Schottky contact 38 is provided in the anode area 14 for communication to other components (not shown) connected thereto.

Preferably, as illustrated, an N+ type doped silicon portion 40 is provided within P- substrate 16, in the anode area 14, substantially in vertical alignment with the Schottky contact 38, in order to prevent a disruption of the silicide/silicon interface which forms the diode, during fabrication process. One should note that this N+ portion 40 could be omitted if the fabricating process is able to contact the silicide layer 26 of the active Schottky area 28 without disruption risk.

The P+ portion 18 which is aligned with the substrate contact 36 is aimed to prevent the creation of a parasitic Schottky effect in the cathode area 12.

The integrated circuit 1 according to the present invention has at least one on-chip Schottky diode 10.

The integrated circuit 1 is preferably a monolithic UHF transponder integrated circuit having on-chip Schottky diodes 10 which are implemented in a voltage rectifier structure for power-supply generation.

The invention also includes a UHF passive transponder comprising such an integrated circuit 1.

Such a transponder has improved reading distance thanks to its small input capacitance and high frequency effectiveness.

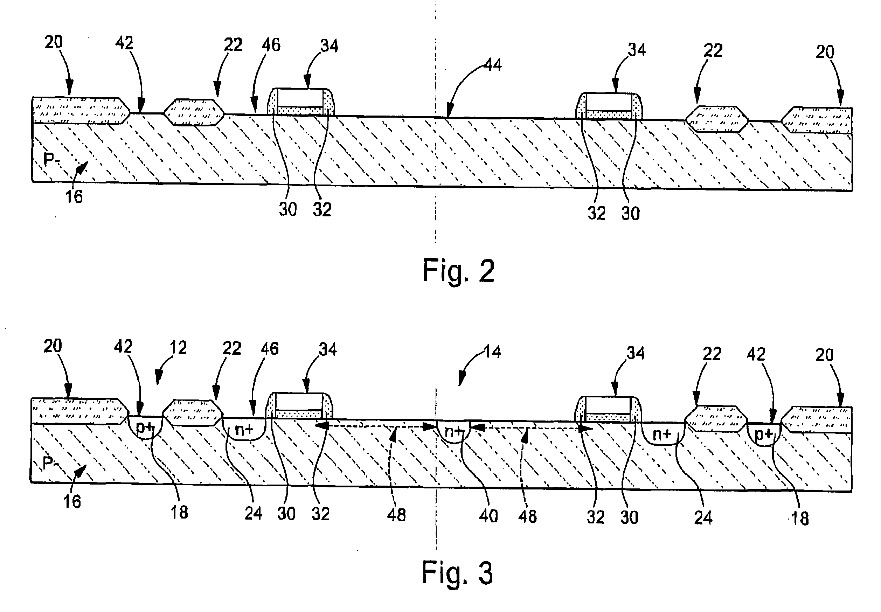

Referring now to figures 2 to 5, a method for fabricating the Schottky diode 10 according to the present invention is disclosed.

As illustrated in figure 2, a polysilicon MOS-gate ring 34 is patterned and etched on the P- substrate 16. The gate ring 34 is provided with a first sidewall oxide 30 at its external edge and a second sidewall oxide 32 at its internal edge forming two narrow insulation rings 30, 32.

Several silicon oxide (SiO2) portions 20, 22 are arranged on the substrate 16 in order to define a contact area 42 for the cathode 12 and an implant area 46 for the guard ring 24.

Then, as illustrated in figure 3, implantation is done to form the P+ doped silicon ring portion 18 in the contact area 42 for the cathode 12, the N+ doped silicon guard ring portion 24 between the MOS-gate ring 34 and the adjacent silicon oxide portion 22, and the N+ doped silicon portion 40 in a contact area 44 for the anode 14.

In order to prevent the extension of the N+ doped region 40 from the anode contact area 44 till the guard ring 24, a no-implant layer 48 that overlaps with the MOS-gate ring 34 is provided for the implantation, which permits to delimitate the contact area 44 for the anode 14.

The N+ implant forming the guard ring 24 is self-aligned relatively to the MOS-gate ring 34. First 30 and second 32 sidewall oxide serve as an implant mask during the formation of the implant guard ring 24.

The substrate provided with the MOS-gate ring 34, after implantation, is shown on figure 3 just prior to silicidation.

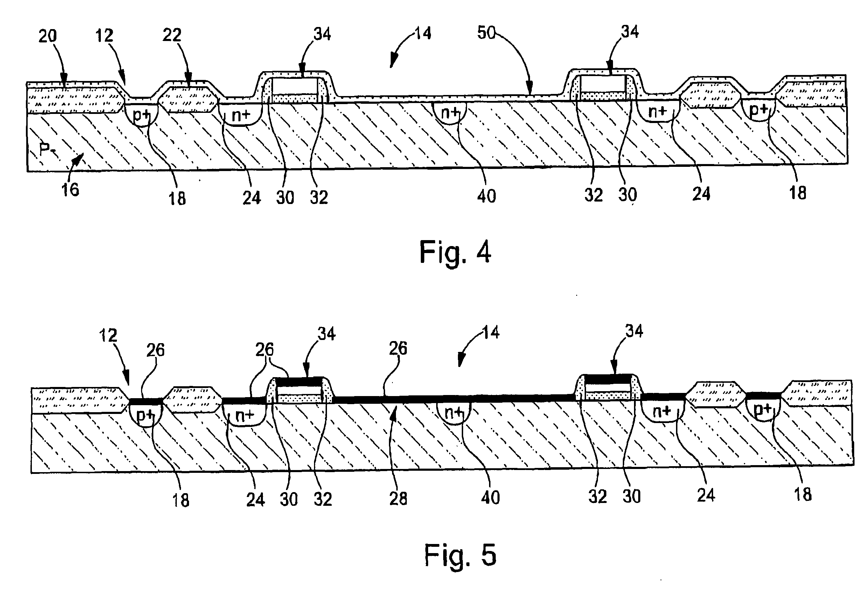

Next, a self-aligned silicide process is operated comprising the deposition of a metal layer 50, as illustrated in figure 4, and a high temperature annealing process which forms the silicide layer 26 and, hence, the silicide/silicon interface, as illustrated in figure 5.

The active Schottky area 28 is formed by the silicide layer 26 delimitated by the internal sidewall oxide 32 of the MOS-gate ring 34.

It should be noted that the self-aligned process for the arrangement of a MOS-gate on a substrate is disclosed in detail in "Development of the Self-Aligned Titanium Silicide Process for VLSI Application", Alperin et al., IEEE Journal of Solid-State Circuits, Vol. sc-20, no. 1, February 1985, hereby incorporated by reference.

Various layers such as an oxide layer 52 could be deposited over the arrangement obtained in figure 5. As shown in figure 1, metal contacts 36, 38 are arranged on the substrate 16 for communication of the Schottky diode 10 with other components.

Advantageously, the MOS-gate ring 34 is connected to a given electric potential such that the MOS-gate 34 is off, in order to prevent electric conduction through the MOS-gate ring 34 from the guard ring 24 to the active Schottky area 28. In the embodiment shown, the MOS-gate ring 34 could be connected to the P-substrate 16, for example through a via (not shown).

The preferred embodiment of the invention as set forth above is intended to be illustrative, not limiting. For instance, while particular types of doped silicon have been disclosed for particular areas of the Schottky diode 10, it is important to note that substitutions of the type of doping can be made as long as the types used are opposites as required for creation of the Schottky diode 10.

## Claims

1. Integrated circuit (1) having at least one on-chip silicide-based CMOS Schottky diode (10) comprising a silicon layer forming a substrate (16) in which is formed an implant guard ring (24) between an active Schottky area (28) and a cathode contact area (19), having a silicide layer (26) which forms the active Schottky area (28) and which covers the guard ring (24), a MOS-gate ring (34) between the guard ring (24) and the active Schottky area (28) in order to provide an insulation element between the guard ring (24) and the active Schottky area (28) **characterized in that** the guard ring is a floating guard ring (24) which is enable to reduce the current leakage without adding capacitance in said diode.

2. Integrated circuit (1) according to the preceding claim, **characterized in that** MOS-gate comprise an insulation external sidewall (30) between the guard ring (24) and its own ring (34) in order to obtain a floating guard ring.

3. Integrated circuit (1) according to the claim 1 or 2, **characterized in that** MOS-gate comprise an insulation internal sidewall (32) between the Schottky area (28) and its own ring (34) in order to obtain a floating guard ring.

4. Integrated circuit (1) according to anyone of the preceding claims, **characterized in that** the MOS-gate ring (34) is connected to a given electric potential in order to prevent conduction between the guard ring (24) and the active Schottky area (28) through the MOS-gate ring (34).

5. Integrated circuit (1) according to anyone of the preceding claims, **characterized in that** an implant portion (40) is provided in the substrate (16), below the active Schottky area (28) and a metal Schottky contact (38), in order to prevent a disruption of the silicide/silicon interface which forms the diode during fabrication process.

6. Integrated circuit (1) according to anyone of the preceding claims, **characterized in that** the Schottky diode (10) is implemented in a voltage rectifier structure for power supply generation.

7. Very high frequency passive transponder **characterized in that** it comprises an integrated circuit (1) according to anyone of the preceding claims.

8. Method for fabricating a Schottky diode (10) in a silicide-based CMOS process from a silicon layer forming a substrate (16), **characterized in that** it comprises the steps of :
- etching a polysilicon MOS-gate ring (34) on the substrate (16) with an internal (32) and an external (30) insulation sidewall.
- implant in the substrate (16) a guard ring (24) adjacent to the external sidewall (30) of the MOS-gate ring (34),
- depositing a metal layer (50) over the substrate (16) and the MOS-gate ring (34),
- forming a silicide layer (26) from the metal layer (50) such that the silicide/silicon interface forms an active Schottky area (28) delimitated by the MOS-gate ring (34).

9. Method according to the preceding claim, **characterized in that** a self-aligned silicide process is used in order to obtain a self-aligned guard ring (24) by using sidewalls (30; 32) as implant mask.

10. Method according to claim 8 or 9, **characterized in that**, before the deposition of the metal layer (50), an implant portion (40) is provided in a region of the substrate (16) corresponding to the active Schottky area (28), below a Schottky contact area (44), in order to prevent a disruption of the silicide/silicon interface which forms the diode when contacting the active Schottky area (28).

## Patentansprüche

1. Integrierter Schaltkreis (1), welcher wenigstens eine auf dem Chip ausgeführte auf einem Silizid basierende CMOS-Schottky-Diode (10) besitzt, die eine Siliziumschicht umfasst, die ein Substrat (16) bildet, in dem ein implantierter Schutzring (24) zwischen einem aktiven Schottky-Bereich (28) und einem Kathodenkontaktbereich (19) gebildet ist, welcher eine Silizidschicht (26) besitzt, die den aktiven Schottky-Bereich (28) bildet, und den Schutzring (24) bedeckt, einen MOS-Gate Ring (34) zwischen dem Schutzring (24) und dem aktiven Schottky-Bereich (28), um ein Isolierungselement zwischen dem Schutzring (24) und dem aktiven Schottky Bereich (28) bereit zu stellen, **dadurch gekennzeichnet, dass** der Schutzring ein erdfreier Schutzring (24) ist, der in der Lage ist, den Leckstrom zu verringern, ohne Kapazität in der Diode hinzuzufügen.

2. Integrierter Schaltkreis (1) gemäss dem vorstehenden Anspruch, **dadurch gekennzeichnet, dass** das MOS-Gate eine äussere Isolationsseitenwand (30) zwischen dem Schutzring (24) und seinem eigenen Ring (34) umfasst, um einen erdfreien Schutzring zu erhalten.

3. Integrierter Schaltkreis (1) gemäss Anspruch 1 oder 2, **dadurch gekennzeichnet, dass** das MOS-Gate eine innere lsolationsseitenwand (32) zwischen dem Schottky-Bereich (28) und seinem eigenen Ring (34) umfasst, um einen erdfreien Schutzring zu erhalten.

4. Integrierter Schaltkreis (1) gemäss einem der vorstehenden Ansprüche, **dadurch gekennzeichnet, dass** der MOS-Gate-Ring (34) mit einem bestimmten elektrischen Potential verbunden ist, um Leitung zwischen dem Schutzring (24) und dem aktiven Schottky-Bereich (28) durch den MOS-Gate Ring (34) zu vermeiden.

5. Integrierter Schaltkreis (1) gemäss einem der vorstehenden Ansprüche, **dadurch gekennzeichnet, dass** ein implantierter Bereich (40) in dem Substrat (16) vorgesehen ist, unter dem aktiven Schottky-Bereich (28) und einem metallischen Schottky-Kontakt (38), um eine Unterbrechung der Silizid/Silizium Schnittstelle zu vermeiden, die die Diode während des Herstellungsverfahren ausbildet.

6. Integrierter Schaltkreis (1) gemäss einem der vorstehenden Ansprüche, **dadurch gekennzeichnet, dass** die Schottky-Diode (10) in eine Spannungsgleichrichterstruktur zum Erzeugen einer Spannungsversorgung implementiert ist.

7. Passiver Transponder mit sehr hoher Frequenz **dadurch gekennzeichnet, dass** er einen integrierten Schaltkreis (1) nach einem der vorstehenden Ansprüche umfasst.

8. Verfahren zum Herstellen einer Schottky-Diode (10) in einem auf einem Silizid basierten CMOS-Verfahren aus einer ein Substrat (16) bildenden Silizium Schicht, **dadurch gekennzeichnet, dass** es folgende Schritte umfasst:
Ätzen eines Polysilizium-MOS-Gate Rings (34) auf das Substrat (16) mit einer inneren (32) und einer äusseren (30) Isolationsseitenwand,
- Implantieren eines an die äussere Seitenwand (30) des MOS-Gate Rings (34) anliegenden Schutzrings (24) in das Substrat (16),
- Abscheiden einer Metallschicht (50) auf dem Substrat (16) und dem MOS-Gate Ring (34),
- Bilden einer Silizidschicht (26) aus der Metallschicht (50), so dass die Silizid/Silizium Schnittstelle einen aktiven Schottky Bereich (28) bildet, der von dem MOS-Gate Ring (34) begrenzt ist.

9. Verfahren gemäss dem vorstehenden Anspruch, **dadurch gekennzeichnet, dass** ein sich selbst ausrichtendes Silizidverfahren verwendet wird, um einen selbst ausgerichteten Schutzring (24) zu erhalten, indem man die Seitenwände (30; 32) als Implantiermaske verwendet.

10. Verfahren nach Anspruch 8 oder 9, **dadurch gekennzeichnet, dass** vor dem Abscheiden der Metallschicht (50) unterhalb eines Schottky-Kontaktbereichs (44) ein Implantatbereich (40) in einem Bereich des Substrates (16) bereitgestellt wird, der dem aktiven Schottky-Bereich (28) entspricht, um eine Unterbrechung der Silizid/Silizium Schnittstelle zu vermeiden, die die Diode bildet, wenn der aktive Schottky-Bereich (28) kontaktiert wird.

## Revendications

1. Circuit intégré (1) ayant au moins une diode Schottky CMOS (10) à base de siliciure intégré, comprenant une couche de silicium formant un substrat (16), dans lequel est formé un anneau de garde implanté (24) entre une zone Schottky active (28) et une zone de contact cathodique (19), avec une couche de siliciure (26), qui forme la zone Schottky active (28) et qui recouvre l'anneau de garde (24), un anneau de grille MOS (34) entre l'anneau de garde (24) et la zone Schottky active (28) pour fournir un élément d'isolation entre l'anneau de garde (24) et la zone Schottky active (28), **caractérisé en ce que** l'anneau de garde est un anneau de garde flottant (24), qui est capable de réduire le courant de fuite sans ajouter de capacité dans ladite diode.

2. Circuit intégré (1) selon la revendication précédente, **caractérisé en ce que** la grille MOS comprend une paroi externe d'isolation (30) entre l'anneau de garde (24) et son propre anneau (34) pour obtenir un anneau de garde flottant.

3. Circuit intégré (1) selon la revendication 1 ou 2, **caractérisé en ce que** la grille MOS comprend une paroi interne d'isolation (32) entre la zone Schottky (28) et son propre anneau (34) pour obtenir un anneau de garde flottant.

4. Circuit intégré (1) selon l'une des revendications précédentes, **caractérisé en ce que** l'anneau de grille MOS (34) est connecté à un potentiel électrique donné pour empêcher la conduction entre l'anneau de garde (24) et la zone Schottky active (28) à travers l'anneau de grille MOS (34).

5. Circuit intégré (1) selon l'une des revendications précédentes, **caractérisé en ce qu'**une portion d'implant (40) est prévue dans le substrat (16) sous la zone Schottky active (28) et un contact Schottky métallique (38), pour empêcher une rupture de l'interface siliciure/silicium, qui forme la diode durant le procédé de fabrication.

6. Circuit intégré (1) selon l'une des revendications précédentes, **caractérisé en ce que** la diode Schottky (10) est réalisée dans une structure de redresseur de tension pour la génération d'alimentation électrique.

7. Transpondeur passif à très haute fréquence, **caractérisé en ce qu'**il comprend un circuit intégré (1) selon l'une des revendications précédentes.

8. Procédé de fabrication d'une diode Schottky (10) dans un procédé CMOS à base de siliciure, provenant d'une couche de silicium formant un substrat (16), **caractérisé en ce qu'**il comprend les étapes de :
- graver un anneau de grille MOS en poly-silicium (34) sur le substrat (16) avec une paroi interne d'isolation (32) et une paroi externe d'isolation (30),
- implanter dans le substrat (16), un anneau de garde (24) adjacent à la paroi externe (30) de l'anneau de grille MOS (34),
- déposer une couche métallique (50) sur le substrat (16) et l'anneau de grille MOS (34),
- former une couche de siliciure (26) de la couche métallique (50), telle que l'interface siliciure/silicium forme une zone Schottky active (28) délimitée par l'anneau de grille MOS (34).

9. Procédé selon la revendication précédente, **caractérisé en ce qu'**un procédé à siliciure auto-aligné est utilisé pour obtenir un anneau de garde auto-aligné (24) en utilisant les parois (30; 32) comme masque d'implant.

10. Procédé selon la revendication 8 ou 9, **caractérisé en ce qu'**avant le dépôt de la couche métallique (50), une portion d'implant (40) est prévue dans une région du substrat (16) correspondant à la zone Schottky active (28) sous une zone de contact Schottky (44) pour empêcher une rupture de l'interface siliciure/silicium qui forme la diode en contactant la zone Schottky active (28).
